# EUROPEAN PATENT APPLICATION

(11) **EP 4 012 750 A1**
(43) Date of publication of application: **15.06.2022**
(21) Application number: 20849816.2
(22) Date of filing: 02.07.2020
(51) Int. Cl.: H01L 21/02, H01L 21/20, H01L 27/12, C30B 29/06

(54) **SUBSTRATE FOR ELECTRONIC DEVICE AND PRODUCTION METHOD THEREFOR**

(30) Priority: 06.08.2019 JP 2019144251
(71) Applicant: Shin-Etsu Handotai Co., Ltd., Tokyo 100-0004 (JP)
(72) Inventor: HAGIMOTO, Kazunori, Annaka-shi, Gunma 379-0196 (JP); GOTO, Shouzaburo, Tokyo 100-0004 (JP)
(74) Representative: Sonnenhauser, Thomas Martin
(86) International application number: PCT/JP2020/025934
(87) International publication number: WO 2021/024654

(57) **Abstract**

The present invention is a substrate for an electronic device, including a nitride semiconductor film formed on a joined substrate including a silicon single crystal, where the joined substrate has at least a bond wafer including a silicon single crystal joined on a base wafer including a silicon single crystal, the base wafer includes CZ silicon having a resistivity of 0.1 Qcm or lower and a crystal orientation of <100>, and the bond wafer has a crystal orientation of <111>. This provides a substrate for an electronic device, having a suppressed warp.

## Description

### TECHNICAL FIELD

The present invention relates to: a substrate for an electronic device; and a method for producing the same.

### BACKGROUND ART

Nitride semiconductors, including GaN and AlN, can be used for fabricating high electron mobility transistors (HEMT) and electronic devices with a high breakdown voltage that use two-dimensional electron gas.

It is difficult to produce a nitride wafer having a nitride semiconductor grown on a substrate for such devices, and a sapphire substrate or an SiC substrate is used as the substrate. However, in order to suppress costs for achieving a larger diameter and costs for a substrate, epitaxial growth by vapor deposition on a silicon substrate is employed. When an epitaxially grown film is fabricated by vapor deposition on a silicon substrate, a substrate with a larger diameter can be used compared to when a sapphire substrate or an SiC substrate is used, so that the productivity of devices is high, and there are advantages regarding heat dissipation properties. However, due to stress caused by a difference in lattice constant or a difference in thermal expansion coefficient, an increase in warp and plastic deformation easily occur. Therefore, the reduction of stress is carried out through growth conditions and a relief layer. In addition, it is necessary to use a high resistance silicon substrate for a substrate for high frequencies.

As a measure against warps, an epitaxial layer AlN/Si (1000 Qcm or higher)/Si (100 Qcm or lower) is formed to join a high resistance substrate to a low resistance substrate in Patent Document 1. Meanwhile, in Patent Document 2, an epitaxial layer AlN/Si (CZ, low resistance)/Si (FZ, high resistance) is formed to join a low resistance CZ substrate to a high resistance FZ substrate.

It is desirable for a substrate for fabricating an electronic device (for high breakdown voltage/for RF (radio frequency)) to have a warp amount of 50 µm or less, but conventional techniques still have a problem that the warp amount exceeds 50 µm.

### CITATION LIST

### PATENT LITERATURE

Patent Document 1: WO 2011/016219
Patent Document 2: JP 2014-192226 A

### SUMMARY OF INVENTION

### TECHNICAL PROBLEM

The present invention has been made to solve the above-described problems, and an object thereof is to provide: a substrate for an electronic device for high breakdown voltage or for high frequencies, having a nitride semiconductor formed on a silicon substrate in which warpage has been suppressed; and a method for producing the same.

### SOLUTION TO PROBLEM

To solve the above problems, the present invention provides a substrate for an electronic device, comprising a nitride semiconductor film formed on a joined substrate comprising a silicon single crystal, wherein
the joined substrate has at least a bond wafer comprising a silicon single crystal joined on a base wafer comprising a silicon single crystal,
the base wafer comprises CZ silicon having a resistivity of 0.1 Qcm or lower and a crystal orientation of <100>, and
the bond wafer has a crystal orientation of <111>.

Such a substrate for an electronic device includes a hard base wafer including CZ silicon having a resistivity of 0.1 Qcm or lower and a crystal orientation of <100>, so that the warping of the substrate for an electronic device can be suppressed. In addition, since a bond wafer having a crystal orientation of <111> is joined on the base wafer, a favorable nitride semiconductor film can be formed. Furthermore, since wafers having different crystal orientations of <100> and <111> are joined, the cleavage directions of the wafers are different from each other, so that the substrate for an electronic device hardly breaks. Moreover, when the base wafer has a crystal orientation of <100>, polycrystallization of an ingot during growth can be suppressed. From all of the above, the substrate for an electronic device is optimum for high breakdown voltage or for high frequencies.

In particular, the bond wafer is preferably a CZ silicon substrate having a resistivity of 0.1 Qcm or lower.

With such a bond wafer, the strength of the joined substrate can be further increased. Such a substrate for an electronic device is particularly suitable for a high breakdown voltage device.

In addition, the bond wafer is preferably a CZ silicon substrate having a resistivity of 1000 Qcm or higher and a nitrogen concentration of 1×10¹⁴ atoms/cm³ or higher.

In this manner, a bond wafer which is a CZ silicon substrate is doped with nitrogen, so that strength is further increased. In addition, since the bond wafer has high resistance, the substrate for an electronic device is particularly suitable for a high frequency device.

In addition, the bond wafer is preferably an FZ silicon substrate having a resistivity of 1000 Qcm or higher and a nitrogen concentration of 8×10¹⁴ atoms/cm³ or higher.

In this manner, a bond wafer which is an FZ silicon substrate is doped with nitrogen, so that strength is further increased. In addition, since the bond wafer has high resistance, the substrate for an electronic device is particularly suitable for a high frequency device.

Furthermore, the joined substrate preferably has the base wafer and the bond wafer joined via an SiO₂ film.

In such a joined substrate, stress caused by the nitride semiconductor film can be relieved, and a thicker nitride semiconductor film can be formed.

Furthermore, the present invention provides a method for producing a substrate for an electronic device by forming a nitride semiconductor film on a silicon single crystal substrate, the method comprising the steps of:
obtaining a joined substrate by joining a bond wafer comprising a silicon single crystal on a base wafer comprising a silicon single crystal; and
forming a nitride semiconductor on the bond wafer of the joined substrate by epitaxial growth, wherein
the base wafer comprises CZ silicon having a resistivity of 0.1 Qcm or lower and a crystal orientation of <100>, and
the bond wafer has a crystal orientation of <111>.

In such a method for producing a substrate for an electronic device, a hard base wafer including CZ silicon having a resistivity of 0.1 Qcm or lower and a crystal orientation of <100> is used, so that the warping of the substrate for an electronic device can be suppressed. In addition, since a bond wafer having a crystal orientation of <111> is joined on the base wafer, a favorable nitride semiconductor film can be formed. Furthermore, since wafers having different crystal orientations of <100> and <111> are joined, the cleavage directions of the wafers are different from each other, so that the produced substrate for an electronic device hardly breaks. Moreover, when the base wafer has a crystal orientation of <100>, polycrystallization of an ingot during growth can be suppressed. Therefore, a substrate for an electronic device that is optimum for high breakdown voltage or for high frequencies can be produced.

In this event, the bond wafer is preferably a CZ silicon substrate having a resistivity of 0.1 Qcm or lower.

According to such a production method, the strength of the joined substrate can be further increased. A substrate for an electronic device produced by such a method is particularly suitable for a high breakdown voltage device.

In addition, the bond wafer is preferably a CZ silicon substrate having a resistivity of 1000 Qcm or higher and a nitrogen concentration of 1×10¹⁴ atoms/cm³ or higher.

In a substrate for an electronic device produced by such a method, a bond wafer which is a CZ silicon substrate is doped with nitrogen, so that strength is further increased. In addition, since the bond wafer has high resistance, the substrate for an electronic device can be made particularly suitable for a high frequency device.

In addition, the bond wafer is preferably an FZ silicon substrate having a resistivity of 1000 Ωcm or higher and a nitrogen concentration of 8×10¹⁴ atoms/cm³ or higher.

In a substrate for an electronic device produced by such a method, a bond wafer which is an FZ silicon substrate is doped with nitrogen, so that strength is further increased. In addition, since the bond wafer has high resistance, the substrate for an electronic device can be made particularly suitable for a high frequency device.

Furthermore, the base wafer and the bond wafer are preferably joined via an SiO₂ film in the step of obtaining a joined substrate.

In a substrate for an electronic device produced by such a method, stress caused by the nitride semiconductor film can be relieved, and a thicker nitride semiconductor film can be formed.

### ADVANTAGEOUS EFFECTS OF INVENTION

Such a substrate for an electronic device and method for producing the same include a hard base wafer including CZ silicon having a resistivity of 0.1 Qcm or lower and a crystal orientation of <100>, so that the warping of the substrate for an electronic device can be suppressed. In addition, since a bond wafer having a crystal orientation of <111> is joined on the base wafer, a favorable nitride semiconductor film can be formed. Furthermore, since wafers having different crystal orientations of <100> and <111> are joined, the cleavage directions of the wafers are different from each other, so that the substrate for an electronic device hardly breaks. Moreover, when the base wafer has a crystal orientation of <100>, polycrystallization of an ingot during growth can be suppressed, so that inexpensive production is possible. Thus, the substrate for an electronic device is optimum for high breakdown voltage or for high frequencies.

### BRIEF DESCRIPTION OF DRAWINGS

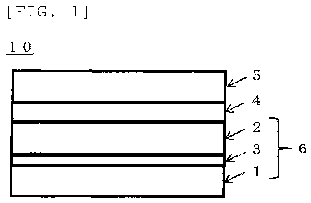

FIG. 1 is a conceptual diagram showing the inventive substrate for an electronic device.

### DESCRIPTION OF EMBODIMENTS

Hereinafter, the present invention will be described in detail, but the present invention is not limited thereto.

As described above, in a substrate for an electronic device for high breakdown voltage/high frequencies, there arises a problem that a warp occurs in a wafer due to a difference in thermal expansion coefficient when an epitaxial layer is stacked thickly in order to enhance device characteristics. To solve this problem, the present inventors have earnestly studied and found out that a nitride semiconductor film can be formed favorably by using a hard silicon substrate having a crystal orientation of <100> and low resistivity as a base wafer and joining a silicon substrate having a crystal orientation of <111> thereon in order to suppress the warping of a substrate for an electronic device. Thus, the present invention has been completed.

### [Substrate for Electronic Device]

The present invention is a substrate for an electronic device, including a nitride semiconductor film formed on a joined substrate including a silicon single crystal, where
the joined substrate has at least a bond wafer including a silicon single crystal joined on a base wafer including a silicon single crystal,
the base wafer includes CZ silicon having a resistivity of 0.1 Qcm or lower and a crystal orientation of <100>, and
the bond wafer has a crystal orientation of <111>.

FIG. 1 shows a conceptual diagram of the inventive substrate for an electronic device.

As shown in FIG. 1, the inventive substrate 10 for an electronic device includes: a joined substrate 6 obtained by joining a base wafer 1 including a silicon single crystal and a bond wafer 2 including a silicon single crystal; and a nitride semiconductor film (device layer) 5 including a nitride. In this event, an intermediate layer 4 may be included between the joined substrate 6 and the device layer 5. In addition, as shown in FIG. 1, the substrate for an electronic device may have a structure having an adhesive layer 3 between the base wafer 1 and the bond wafer 2. The adhesive layer can be, for example, an oxide film (SiO₂).

Here, the base wafer 1 includes a CZ silicon single crystal having a resistivity of 0.1 Qcm or lower and a crystal orientation of <100>. A wafer having such a low resistivity has a high dopant concentration, so that the strength of the substrate can be increased, suppressing warpage. The lower limit of the resistivity is not particularly limited, but the resistivity can be, for example, 0.001 Qcm or higher. In addition, in crystal growth by a CZ method, polycrystallization is less likely to occur during growth when the crystal orientation is <100>, and this is more pronounced with a higher dopant concentration. Therefore, the crystal orientation of the base wafer is set to <100>. In this way, the base wafer can be configured at low cost. In addition, the base wafer preferably has an oxygen concentration of 1×10¹⁸ atoms/cm³ (ASTM'79) or lower.

Meanwhile, the bond wafer 2 to be joined has a crystal orientation of <111>. When the bond wafer 2 has a crystal orientation of <111> as described, a nitride semiconductor film 5 can be formed well, and in particular, a nitride-type epitaxial layer can be well formed by epitaxial growth. Furthermore, when wafers having different crystal orientations <100> and <111> are joined, the wafers have distinct cleavage directions from each other, so that the substrate 10 for an electronic device hardly breaks.

Additionally, the bond wafer 2 can be a CZ silicon substrate having a resistivity of 0.1 Qcm or lower. When the bond wafer 2 also has a low resistivity as described, the strength of the joined substrate can be further increased, and warps can be suppressed further. Moreover, such a substrate for an electronic device can be used suitably for a device for high breakdown voltage. There is no particular limit to the lower limit of the resistivity, but the resistivity can be, for example, 0.001 Qcm or higher. In addition, the bond wafer may have an oxygen concentration of, for example, 1×10¹⁸ atoms/cm³ (ASTM'79) or lower in this event.

Alternatively, the bond wafer 2 can be a CZ silicon substrate having a resistivity of 1000 Qcm or higher and a nitrogen concentration of 1×10¹⁴ atoms/cm³ or higher. When the bond wafer 2 is doped with nitrogen as described, strength is further increased, and in addition, the bond wafer has a high resistance, and therefore, the substrate for an electronic device becomes suitable for a high frequency device. The upper limit of the resistivity is not particularly limited, but the resistivity can be, for example, 10 kΩcm or lower. In addition, the upper limit of the nitrogen concentration is not particularly limited, but the nitrogen concentration can be, for example, 1×10¹⁶ atoms/cm³ or lower. Furthermore, the bond wafer may have an oxygen concentration of, for example, 1×10¹⁸ atoms/cm³ (ASTM'79) or lower in this event.

Alternatively, when the bond wafer 2 is an FZ silicon substrate having a resistivity of 1000 Qcm or higher and a nitrogen concentration of 8×10¹⁴ atoms/cm³ or higher, the strength is further increased by the substrate being doped with nitrogen and the resistance is high, so that the substrate for an electronic device becomes suitable for a high frequency device. Although the upper limit of the resistivity is not particularly limited, the resistivity can be, for example, 10 kΩcm or lower. In addition, although the upper limit of the nitrogen concentration is not particularly limited, the nitrogen concentration can be, for example, 8×10¹⁶ atoms/cm³ or lower.

Additionally, an intermediate layer 4 can be formed on the bond wafer 2. The intermediate layer 4 functions as a buffer layer inserted for improving the crystallinity or controlling stress of the device layer. Since the intermediate layer 4 can be fabricated with the same facility as the nitride semiconductor film 5, the intermediate layer 4 is preferably fabricated using a nitride.

A device layer 5 including a thin film of a nitride such as GaN, AlN, InN, AlGaN, InGaN, and AlInN, for example, is formed on the bond wafer 2. Here, if an intermediate layer 4 is formed, the device layer 5 can be formed on the intermediate layer 4. The device layer 5 can be grown by vapor deposition, for example, by an MOVPE method or sputtering. The nitride thin film can be 1 to 20 µm, and can be designed in accordance with the device.

The inventive substrate for an electronic device includes a hard base wafer including CZ silicon having a resistivity of 0.1 Qcm or lower and a crystal orientation of <100>, so that the warping of the substrate for an electronic device can be suppressed. In addition, since a bond wafer having a crystal orientation of <111> is joined on the base wafer, a favorable nitride semiconductor film can be formed. Furthermore, since wafers having different crystal orientations of <100> and <111> are joined, the cleavage directions of the wafers are different from each other, so that the substrate for an electronic device hardly breaks. Moreover, when the base wafer has a crystal orientation of <100>, polycrystallization of an ingot during growth can be suppressed. Therefore, the substrate for an electronic device is optimum for high breakdown voltage or for high frequencies.

### [Method for Producing Substrate for Electronic Device]

The present invention also provides a method for producing a substrate for an electronic device by forming a nitride semiconductor film on a silicon single crystal substrate, the method including the steps of:
obtaining a joined substrate by joining a bond wafer including a silicon single crystal on a base wafer including a silicon single crystal; and
forming a nitride semiconductor on the bond wafer of the joined substrate by epitaxial growth, where
the base wafer includes CZ silicon having a resistivity of 0.1 Ωcm or lower and a crystal orientation of <100>, and
the bond wafer has a crystal orientation of <111>.

In the inventive production method, a bond wafer including a silicon single crystal is joined on a base wafer including a silicon single crystal to obtain a joined substrate.

In this event, the base wafer used includes CZ silicon having a resistivity of 0.1 Qcm or lower and a crystal orientation of <100>. The lower limit of the resistivity is not particularly limited, but the resistivity can be, for example, 0.001 Qcm or higher. In addition, a base wafer having an oxygen concentration of 1×10¹⁸ atoms/cm³ (ASTM'79) or lower can be used in this event.

Furthermore, in this event, the bond wafer has a crystal orientation of <111>.

As the bond wafer, a CZ silicon substrate having a resistivity of 0.1 Qcm or lower can be used. When a wafer with a low resistivity is also used for the bond wafer as described, the strength can be further increased, and warps can be further suppressed. Moreover, a substrate for an electronic device produced in this manner can be used suitably for a device for high breakdown voltage. The lower limit of the resistivity is not particularly limited, but the resistivity can be, for example, 0.001 Qcm or higher. In addition, a bond wafer having an oxygen concentration of 1×10¹⁸ atoms/cm³ (ASTM'79) or lower can be used in this event.

Alternatively, as the bond wafer, it is also possible to use a CZ silicon substrate having a resistivity of 1000 Qcm or higher and a nitrogen concentration of 1×10¹⁴ atoms/cm³ or higher. When a bond wafer doped with nitrogen is used as described, strength is further increased. In addition, since the resistance is high, the substrate for an electronic device can be made suitable for a high frequency device. In addition, although the upper limit of the resistivity is not particularly limited, the resistivity can be, for example, 10 kΩcm or lower. Furthermore, the upper limit of the nitrogen concentration is not particularly limited, but the nitrogen concentration can be, for example, 1×10¹⁶ atoms/cm³ or lower. In addition, the bond wafer used may have an oxygen concentration of 1×10¹⁸ atoms/cm³ (ASTM'79) or lower in this event.

Alternatively, when an FZ silicon substrate having a resistivity of 1000 Qcm or higher and a nitrogen concentration of 8×10¹⁴ atoms/cm³ or higher is used as the bond wafer, the strength is further increased by using the substrate doped with nitrogen. In addition, the resistance is high, so that the substrate for an electronic device can be made suitable for a high frequency device. The upper limit of the resistivity is not particularly limited, but the resistivity can be, for example, 10 kΩcm or lower. In addition, the upper limit of the nitrogen concentration is not particularly limited, but the nitrogen concentration can be, for example, 8×10¹⁶ atoms/cm³ or lower.

The method for joining the base wafer and the bond wafer is not particularly limited, but the wafers are preferably bonded with an oxide film. In addition, the oxide film before the joining can also be thinned, so that only the oxygen in the oxide film is diffused by a bonding heat treatment after the joining. Thus, it is possible to achieve a structure having no oxide film in the joining interface. By carrying out the adhesion of the silicon single crystal substrates in this manner by using an oxide film, the stress applied during the growth of the nitride can be relieved.

Next, a nitride semiconductor film is epitaxially grown on the joined substrate produced in the above manner. Here, an intermediate layer can be formed before the growth of the nitride semiconductor film. By forming an intermediate layer when growing the nitride to insert an appropriate buffer layer, stress from the thin film due to the difference in thermal expansion coefficient and the difference in lattice constant can be controlled after cooling. In addition, by making the substrate thicker, plastic deformation during high-temperature growth can be prevented, and a wafer with an even smaller warp can be produced. To make the process simpler, it is desirable to fabricate the intermediate layer by using a nitride.

In such a method for producing a substrate for an electronic device, a hard base wafer including CZ silicon having a resistivity of 0.1 Qcm or lower and a crystal orientation of <100> is used, so that the warping of the substrate for an electronic device can be suppressed. In addition, since a bond wafer having a crystal orientation of <111> is joined on the base wafer, a favorable nitride semiconductor film can be formed. Furthermore, since wafers having different crystal orientations of <100> and <111> are joined, the cleavage directions of the wafers are different from each other, so that the produced substrate for an electronic device hardly breaks. Moreover, when the base wafer has a crystal orientation of <100>, polycrystallization of an ingot during growth can be suppressed. Therefore, a substrate for an electronic device that is optimum for high breakdown voltage or for high frequencies can be produced.

### EXAMPLE

Hereinafter, the present invention will be described more specifically with reference to Examples and Comparative Examples, but the present invention is not limited to the following Examples.

### (Example 1)

A base wafer (diameter: 150 mm) having a thickness of 500 µm and a base wafer (diameter: 150 mm) having a thickness of 1000 µm were prepared from (100) plane CZ silicon substrates each having a resistivity of 0.1 Qcm or lower and an oxygen concentration of 1×10¹⁸ atoms/cm³ (ASTM'79) or lower (resistivity: 0.007 Qcm, oxygen concentration: 7×10¹⁷ atoms/cm³). In addition, for bonding, two bond wafers (diameter: 150 mm) each having a thickness of 500 µm were prepared from (111) plane CZ silicon substrates each having a resistivity of 0.1 Qcm or lower and an oxygen concentration of 1×10¹⁸ atoms/cm³ (ASTM'79) or lower (resistivity: 0.007 Qcm, oxygen concentration: 7×10¹⁷ atoms/cm³).

Next, substrates for an electronic device like the substrate shown in FIG. 1 were fabricated in the following manner. The two base wafers 1 were each subjected to thermal oxidation (thickness: 1 µm), and the two bond wafers 2, having been polished on both sides, were each subjected to thermal oxidation (thickness: 1 µm). Then, through a bonding process, a bonding heat treatment was performed at 1150°C for 2 hours. Subsequently, the bond wafers of the bonded substrates were ground and polished to make the thickness of the bond wafers in the substrates 200 µm. Then, for oxide film removal, the obtained substrates were immersed in 10% HF to remove a surface oxide film. Thus, joined substrates 6 respectively having a thickness of 700 µm and 1200 µm were obtained. After that, on the fabricated joined substrates 6, epitaxial growth of GaN with a thickness of 5 µm (intermediate layer: 2.5 µm, device layer: 2.5 µm) was performed in an MOVPE furnace. The warp in this event was 35 µm with the joined substrate 6 having the thickness of 700 µm, and 20 µm with the joined substrate 6 having the thickness of 1200 µm.

### (Example 2)

A base wafer (diameter: 150 mm) having a thickness of 500 µm and a base wafer (diameter: 150 mm) having a thickness of 1000 µm were prepared from (100) plane CZ silicon substrates each having a resistivity of 0.1 Qcm or lower and an oxygen concentration of 1×10¹⁸ atoms/cm³ (ASTM'79) or lower (resistivity: 0.007 Qcm, oxygen concentration: 7×10¹⁷ atoms/cm³). In addition, for bonding, two bond wafers (diameter: 150 mm) each having a thickness of 500 µm were prepared from (111) plane CZ silicon substrates of 1000 Qcm or higher doped with nitrogen at a high concentration (8×10¹⁴ atoms/cm³, 5000 Qcm).

Next, substrates for an electronic device like the substrate shown in FIG. 1 were fabricated in the following manner. The two base wafers 1 were subjected to thermal oxidation (thickness: 1 µm), and the two bond wafers 2, having been polished on both sides, were subjected to thermal oxidation (thickness: 1 µm). Then, through a bonding process, a bonding heat treatment was performed at 1150°C for 2 hours. Subsequently, the bond wafers of the bonded substrates were ground and polished to make the thickness of the bond wafers in the substrates 200 µm. Then, for oxide film removal, the obtained substrates were immersed in 10% HF to remove a surface oxide film. Thus, joined substrates respectively having a thickness of 700 µm and 1200 µm were obtained. After that, on the fabricated joined substrate thicknesses, epitaxial growth of GaN with a thickness of 5 µm (intermediate layer: 2.5 µm, device layer: 2.5 µm) was performed in an MOVPE furnace. The warp in this event was 40 µm with the joined substrate having the thickness of 700 µm, and 20 µm with the joined substrate having the thickness of 1200 µm.

### (Example 3)

A base wafer (diameter: 150 mm) having a thickness of 500 µm and a base wafer (diameter: 150 mm) having a thickness of 1000 µm were prepared from (100) plane CZ silicon substrates each having a resistivity of 0.1 Qcm or lower and an oxygen concentration of 1×10¹⁸ atoms/cm³ (ASTM'79) or lower (resistivity: 0.007 Qcm, oxygen concentration: 7×10¹⁷ atoms/cm³). In addition, for bonding, two bond wafers (diameter: 150 mm) each having a thickness of 500 µm were prepared from (111) plane FZ silicon substrates of 1000 Ωcm or higher doped with nitrogen at a high concentration (8×10¹⁴ atoms/cm³, 5000 Ωcm).

The base wafers 1 were subjected to thermal oxidation (thickness: 1 µm), and the bond wafers 2, having been polished on both sides, were subjected to thermal oxidation (thickness: 1 µm). Then, through a bonding process, a bonding heat treatment was performed at 1150°C for 2 hours. Subsequently, the bond wafers of the bonded substrates were ground and polished to make the thickness of the bond wafers in the substrates 200 µm. Then, for oxide film removal, the obtained substrates were immersed in 10% HF to remove a surface oxide film. Thus, joined substrates respectively having a thickness of 700 µm and 1200 µm were obtained. After that, on the fabricated joined substrates, epitaxial growth of GaN with a thickness of 5 µm (intermediate layer: 2.5 µm, device layer: 2.5 µm) was performed in an MOVPE furnace. The warp in this event was 45 µm with the joined substrate having the thickness of 700 µm, and 20 µm with the joined substrate having the thickness of 1200 µm.

### (Comparative Example 1)

A wafer (diameter: 150 mm) having a thickness of 700 µm was prepared from a (111) plane CZ silicon substrate having a resistivity of 20 Ωcm and an oxygen concentration of 5×10¹⁸ atoms/cm³. On this substrate, epitaxial growth of GaN with a thickness of 5 µm was performed in an MOVPE furnace. The warp after the growth was 130 µm, which is large.

### (Comparative Example 2)

A base wafer (diameter: 150 mm) having a thickness of 500 µm and a base wafer (diameter: 150 mm) having a thickness of 1000 µm were prepared from (100) plane CZ silicon substrates each having a resistivity of 0.1 Ωcm or lower and an oxygen concentration of 1×10¹⁸ atoms/cm³ (ASTM'79) or lower (resistivity: 0.007 Ωcm, oxygen concentration: 7×10¹⁷ atoms/cm³). In addition, for bonding, two bond wafers (diameter: 150 mm) each having a thickness of 500 µm were prepared from (100) plane CZ silicon substrates having the same resistivity and oxygen concentration as the base wafers.

Next, the two base wafers were each subjected to thermal oxidation (thickness: 1 µm), and the two bond wafers, having been polished on both sides, were each subjected to thermal oxidation (thickness: 1 µm). Then, through a bonding process, a bonding heat treatment was performed at 1150°C for 2 hours. Subsequently, the bond wafers of the bonded substrates were ground and polished to make the thickness of the bond wafers in the substrates 200 µm. Then, for oxide film removal, the obtained substrates were immersed in 10% HF to remove a surface oxide film. Thus, substrates respectively having a thickness of 700 µm and 1200 µm were obtained. After that, on the fabricated substrates, epitaxial growth of GaN with a thickness of 5 µm (intermediate layer: 2.5 µm, device layer: 2.5 µm) was performed in an MOVPE furnace. However, in Comparative Example 2, the epitaxial growth was performed on a (100) plane, so that the formed epitaxial layer had many defects, and it was not possible to perform the epitaxial growth properly in the first place.

From the above results, when a joined substrate was obtained by bonding a bond wafer having a crystal orientation of <111> on a (100) plane CZ silicon substrate having a low resistivity as in Examples 1 to 3, the warp of the wafer was less than 50 µm, which is sufficiently small for a substrate for fabricating an electronic device, when a nitride semiconductor film was formed. On the other hand, in Comparative Example 1, in which a (111) plane CZ silicon substrate was used, the substrate was soft, so that the warp of the wafer when the nitride semiconductor film was formed was larger than in Examples 1 to 3. Meanwhile, in Comparative Example 2, in which a substrate obtained by bonding two (100) plane CZ silicon substrates each having a low resistivity was used, the epitaxial layer had many defects, and the wafer was breakable.

The present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A substrate for an electronic device, comprising a nitride semiconductor film formed on a joined substrate comprising a silicon single crystal, wherein
the joined substrate has at least a bond wafer comprising a silicon single crystal joined on a base wafer comprising a silicon single crystal,
the base wafer comprises CZ silicon having a resistivity of 0.1 Qcm or lower and a crystal orientation of <100>, and
the bond wafer has a crystal orientation of <111>.

2. The substrate for an electronic device according to claim 1, wherein the bond wafer is a CZ silicon substrate having a resistivity of 0.1 Qcm or lower.

3. The substrate for an electronic device according to claim 1, wherein the bond wafer is a CZ silicon substrate having a resistivity of 1000 Ωcm or higher and a nitrogen concentration of 1×10¹⁴ atoms/cm³ or higher.

4. The substrate for an electronic device according to claim 1, wherein the bond wafer is an FZ silicon substrate having a resistivity of 1000 Ωcm or higher and a nitrogen concentration of 8×10¹⁴ atoms/cm³ or higher.

5. The substrate for an electronic device according to any one of claims 1 to 4, wherein the joined substrate has the base wafer and the bond wafer joined via an SiO₂ film.

6. A method for producing a substrate for an electronic device by forming a nitride semiconductor film on a silicon single crystal substrate, the method comprising the steps of:
obtaining a joined substrate by joining a bond wafer comprising a silicon single crystal on a base wafer comprising a silicon single crystal; and
forming a nitride semiconductor on the bond wafer of the joined substrate by epitaxial growth, wherein
the base wafer comprises CZ silicon having a resistivity of 0.1 Qcm or lower and a crystal orientation of <100>, and
the bond wafer has a crystal orientation of <111>.

7. The method for producing a substrate for an electronic device according to claim 6, wherein the bond wafer is a CZ silicon substrate having a resistivity of 0.1 Qcm or lower.

8. The method for producing a substrate for an electronic device according to claim 6, wherein the bond wafer is a CZ silicon substrate having a resistivity of 1000 Ωcm or higher and a nitrogen concentration of 1×10¹⁴atoms/cm³ or higher.

9. The method for producing a substrate for an electronic device according to claim 6, wherein the bond wafer is an FZ silicon substrate having a resistivity of 1000 Ωcm or higher and a nitrogen concentration of 8×10¹⁴ atoms/cm³ or higher.

10. The method for producing a substrate for an electronic device according to any one of claims 6 to 9, wherein the base wafer and the bond wafer are joined via an SiO₂ film in the step of obtaining a joined substrate.
